# EUROPEAN PATENT APPLICATION

(11) **EP 2 923 847 A1**
(43) Date of publication of application: **30.09.2015**
(21) Application number: 15161445.0
(22) Date of filing: 27.03.2015
(51) Int. Cl.: B41J 11/00

(54) **Printing unit and printing apparatus**

(30) Priority: 28.03.2014 IT UD20140057
(71) Applicant: New System S.r.l., 34170 Gorizia (IT)
(72) Inventor: Vodopivec, Mitja, 33040 Faedis (UD) (IT); bogar, Rajko, 5000 Nova Gorica (SI)
(74) Representative: Fabro., Lorenzo

(57) **Abstract**

According to the present application, a printing unit (1) is provided. The printing unit may include a first print head (50), a second print head (52), a UV pinning light source (54) between the first print head (50) and the second print head (52) and a UV curing light source (56) on an outer side of one or the other of the first print head and second print head. A printing apparatus (60) of the type that uses liquid ink for printing on the surfaces of printed circuit boards is also provided. With the present application, it is possible to print high resolution images in one single pass.

## Description

### TECHNICAL FIELD

Embodiments of the present application relate to a printing unit, configured in such a way as to provide enhanced printing quality, i.e. high image resolution.

The present application relates also to an ink jet printing apparatus including a printing unit according to the present disclosure.

### BACKGROUND

A printed circuit board (PCB) is a device that mechanically supports and electrically connects electronic components using conductive tracks, pads and other features etched from copper sheets laminated onto a nonconductive substrate. PCB's can be single sided, i.e. one copper layer, double sided, i.e. two copper layers, or multi-layer. Conductors on different layers are connected with plated-through holes, typically called vias. Advanced PCB's may contain components - capacitors, resistors or active devices - embedded in the substrate. PCB's are used in all but the simplest electronic products. PCB's normally require design effort to layout the circuit but once that is done, the manufacture and assembly can use automation. Legends are often printed on one or both sides of the PCB, containing indications helpful in assembling, testing and servicing the circuit board.

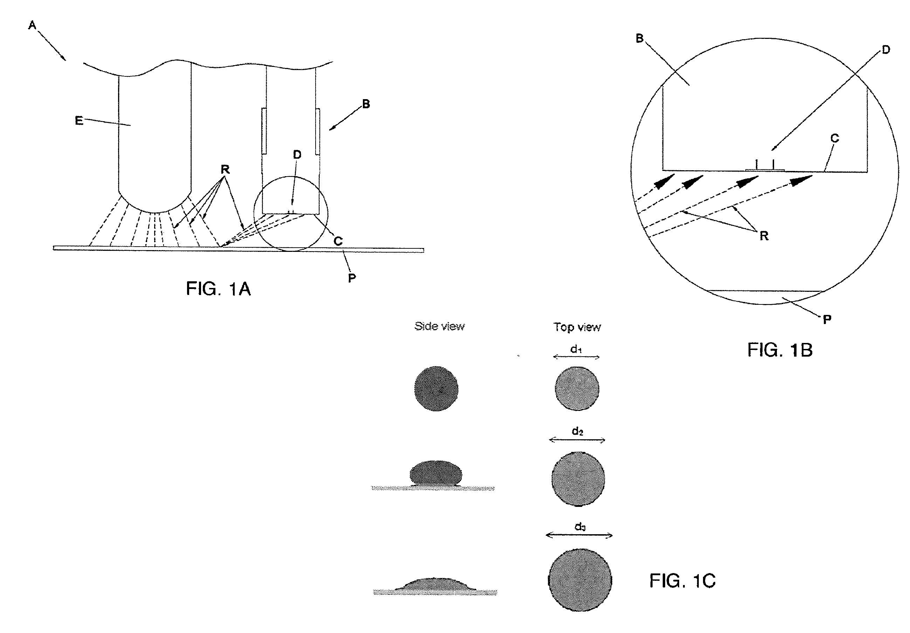

One known method to print the legend is ink jet printing. Figure 1 shows a schematic view of a printing unit A. As is known, the printing unit A can be used on ink jet printing systems configured so as to make it possible to print the legends (e.g. letters, numbers and/or geometrical shapes) on various types of materials such as printed circuit boards or PCBs.

The printing unit A includes a print head B provided with a plurality of nozzles D, and distributed on a printing surface C.

Said plurality of nozzles D ejects the ink in the form of drops, so as to print said legends on a printing plane P where the printed circuit board is arranged.

Typically, the printing unit A is arranged at a predefined distance from said printing plane P and is capable of moving parallel to and above the same, along two directions X and Y that are orthogonal to each other, according to a predefined printing program.

In particular, it is known to use ultraviolet (UV) curable inks, i.e. UV-sensitive inks. Printing with UV curable inks requires the use of a UV light source to transform the ink from its liquid to solid state. Therefore, typically the printing unit A is provided also with a light source E that in the specific case emits light rays R at UV wavelength. Said light source E is integrally coupled with the print head B, so that when the printing unit A is arranged at said predefined distance from the printing plane P, the printing surface C and the light source E are oriented towards said printing plane P.

In this way, once a liquid ink drop has been ejected onto the printing plane P by the plurality of nozzles D, the rays R emitted by the light source E cure the ink, i.e. ensure the polymerization of the ink.

The exact moment at which the transition of the ink from its liquid to solid state occurs strongly affects the final printing result.

In most electronics applications, it is desirable to obtain the smallest possible spot size at a given ink drop volume. After the ink drop lands on a surface, it starts to expand with its shape changing, from a sphere to a disc, see e.g. Figures 1c and increasing diameter d₁, d₂ and d₃. This expansion can be stopped by increasing the ink viscosity exposing the ink drop to UV light. For stopping expansion, generally it is not required to completely cure the ink, it is sufficient to increase its viscosity to the point where it stops to expand, the so called UV pinning.

Therefore, UV pinning is called the process of applying a low dose of UV energy to a UV curable ink. Generally, it is desirable that the light's wavelength is correctly matched to the ink's photochemical properties. As a result, the ink droplets move to a higher viscosity state, but stop short of full cure. This is also referred to as the "gelling" of the ink.

To keep the drop size small, one needs to put a UV light source as close as possible to the print head, so that the time interval between jetting and pinning is the shortest, at a fixed print head movement speed.

It is desirable that, when printing an image, the various drops composing the image have a certain level of overlapping so that the whole surface is well covered, without any unwanted gaps on the boundary between one drop and the next one. This process of ink drop overlapping could be extremely critical because of a delicate surface tension balance: if an ink drop in its liquid form is laying on the surface and a new ink drop arrives touching the first one, then the two drops will merge in a single big drop; this interaction between the two drops will negatively affect the printing quality, because the first drop will be deformed and it will move out of its correct position and also the second one will do the same.

This negative behavior on ink overlapping may strongly limit the maximum resolution at which a printing system can print in a single printing pass while maintaining the maximum printing quality. Resolution is typically expressed in DPI (dots per inch), i.e. the number of individual dots that can be placed in a line within the span of 1 inch (2.54 cm). The ratio of the resolution value expressed in DPI to 1 inch can define a step of a grid in which the drops are distributed.

A printing unit including one print head can generate drops of defined volume, which translates into a well defined spot size, and it has a predefined printing resolution. Drops are therefore distributed in a grid of a priori known step. Depending on the spot size and the grid step values, the printing operation may leave a gap between two neighbor drops.

In an attempt to increase the printing resolution, two print heads can for instance be installed, where one is shifted by half grid step with respect to the other, so that the grid step is 50% reduced and the drops can overlap almost 50%. However, this can result in a noticeable decrease of printing quality in one pass printing, because of the adverse interaction between drops in liquid state as explained above.

There is therefore a need to improve a printing unit and a printing apparatus to overcome at least one of the drawbacks of the prior art.

In particular, there is a need to provide a printing unit and a printing apparatus which are capable of printing high resolution images in one single pass, i.e. images which have resolution equivalent to resolution of images obtainable by two low resolution images printing passes. Moreover, as can be observed in the diagram shown in Figures 1a and 1b, when traditional printing units A are used, said light rays R are disadvantageously reflected by the printing plane P and part of the same directly hits the printing surface C.

As already explained, said incidence of the UV rays on the printing surface C causes the ink to solidify and consequently obstruct the orifices of the plurality of nozzles D.

This makes it disadvantageously necessary to untimely replace the print head B.

In order to solve this problem, the known art proposes two different main solutions.

According to the first known solution, the print head B is mechanically and manually cleaned by rubbing a special cloth on the printing surface C.

This procedure makes it possible to effectively remove the accumulated ink from the printing surface C.

However, to disadvantage, since said UV-sensitive ink has a strong abrasive component, the combination of this characteristic with the rubbing action tends to remove from the printing surface C also the special, so-called "anti-wetting" substance that is applied to it in order to reduce its surface tension.

As already explained above, in fact, a low surface tension makes it possible to improve the printing quality.

Therefore, although this technique solves the problem caused by the presence of solidified ink on the printing surface C, the increase in the surface tension of the same surface C causes a considerable and rapid worsening of the printing quality, which eventually leads to the need to untimely replace the print head B.

According to the second known solution proposed, the printing system is equipped with a cleaning station, not shown in the figures, usually located beside the printing plane P and configured in such a way as to remove the excess ink from the printing surface C of the print head B at regular time intervals between a printing operation and the successive one.

Usually, said ink removal operation is carried out by a suction element that is configured in such a way as to generate a suction of the air on the printing surface C.

However, although this suction cleaning technique seems to solve the problem caused by the presence of ink on the printing surface C in any case the printing quality of the printing unit A of the known art worsens progressively and rapidly in an irreparable manner.

Therefore, even for the printing systems of the known art where the second known solution has been adopted, the need to untimely replace the print head B has disadvantageously arisen.

### SUMMARY

The present application aims to overcome the drawbacks listed above.

According to one embodiment, a printing unit configured for ink-jet printing on a substrate is provided. The printing unit includes a first print head, a second print head, a UV pinning light source between the first print head and the second print head and a UV curing light source on an outer side of one or the other of the first print head and second print head. According to a further embodiment, the UV curing light source is disposed on an outer side of the second print head.

According to yet a further embodiment, each of the first print head and second print head is provided with one or more rows of nozzles configured for ink-jetting.

According to yet a further embodiment, a printing apparatus is provided. The printing apparatus includes a printing unit configured for ink-jet printing on a substrate. The printing unit includes a first print head, a second print head, a UV pinning light source between the first print head and the second print head and a UV curing light source on an outer side of one or the other of the first print head and second print head. The printing apparatus further includes a printing substrate support configured for supporting the substrate during a printing process. According to yet a further embodiment, the printing apparatus includes one or more actuation members configured for moving the printing unit and the substrate one relative to the other.

According to yet a further embodiment, a method for ink-jet printing on a substrate is provided. The method includes executing a first printing operation on the substrate, followed by UV pinning, by a second printing operation and by UV curing afterward.

According to yet a further embodiment, an apparatus for ink-jet printing on a substrate is provided. The apparatus includes a printing unit, a printing substrate support configured to support the substrate, a system controller and a computer program memorizable in a memory readable by a computer that contains the instructions which, when carried out by the system controller, determine the execution of embodiments of a method for ink-jet printing on a substrate including executing a first printing operation on the substrate, followed by UV pinning, by a second printing operation and by UV curing afterward.

Yet a further embodiment results from the fact that the inventors, after performing several tests in different operating conditions, discovered that, although the use of said cleaning station seemed to allow the complete removal of the ink accumulated on the printing surface C, on the latter there still was a layer - invisible to the microscope - of particles belonging to said ink and having a high degree of polymerization.

According to embodiments, the inventors discovered that said particles, if hit by UV light rays with sufficient polymerization energy, tend to polymerize on the printing surface C and with the successive printing cycles said accumulation of particles progressively increases, until making the anti-wetting action of said substance present on the printing surface C totally ineffective.

Therefore, as this anti-wetting effect diminishes, also in this case the surface tension of the printing surface C increases, and consequently the printing quality rapidly decreases.

In the attempt to solve the above mentioned problem, the simplest and most obvious solution that the person skilled in the art may adopt consists in moving the light source E away from the print head B, thus reducing the probability that the UV light rays reflected by the printing plane P may have sufficient polymerization energy upon reaching the printing surface C.

However, to disadvantage, moving the light source E away from the print head B means worsening the printing quality, which is unacceptable in many applications, in particular when printing on printed circuit boards. Therefore, there is a need to provide a printing unit that is capable of avoiding the polymerization as well as the accumulation of said highly polymerizable particles on its printing surface and, consequently, of maintaining a high printing quality for a longer time compared to the solutions of the known art, in the same operating conditions.

At the same time, there is a further need to provide a printing unit that is capable of maintaining high printing accuracy.

In particular, according to yet a further embodiment, the printing unit includes a covering element that rests on and covers the printing surface of the print head, said covering element being shaped and sized in such a way as to allow the ink to be ejected through the plurality of nozzles towards the printing plane. At the same time, said covering element is sized in such a way as to prevent the light rays emitted by the light source and reflected by the printing plane from hitting the printing surface directly.

To advantage, said covering element is capable to protect the printing surface from accidental mechanical contact with the printing plane. The objectives described above are also achieved by a printing apparatus including a printing unit according to the embodiments described herein and by the use of said covering element arranged so that it rests on and covers the printing surface of a printing unit, according to embodiments described herein.

Further characteristics of a printing unit according to embodiments described herein are described in the present disclosure.

In particular, the characteristic regarding the fact that the covering element is removably arranged so that it rests on the printing surface through coupling members, advantageously makes it possible to facilitate any replacement of the covering element and also allows any cleaning operation to be comfortably carried out on the printing surface.

Furthermore, the characteristics regarding the special shape of the covering element and of said coupling members, constituted by a frame, make it possible to obtain an optimal coupling between the covering element and the printing surface. At the same time, said configuration advantageously makes it possible to maintain substantially unchanged the distance defined between the printing surface and the printing plane, compared to the printing units that are not provided with said covering element.

In fact, it is known that the shorter said distance, the higher the printing accuracy.

In yet a further embodiment of the present application, a printing unit is provided. The printing unit may include a print head provided with a plurality of nozzles arranged on a printing surface and configured to eject liquid ink, at least one light source integrally coupled with said print head, said printing unit being configured so that it can be arranged at a predefined distance from a printing plane on which the printing operation is performed, with the printing surface and said at least one light source oriented towards said printing plane. The printing unit may also include a covering element arranged with its internal surface resting on and covering said printing surface and provided with one or more apertures shaped in such a way as to allow said liquid ink to be ejected through said plurality of nozzles towards said printing plane, said covering element and said apertures being sized so as to prevent the light rays emitted by said at least one light source and reflected by said printing plane from passing through said apertures and directly hitting said printing surface.

According to an embodiment of the present application, said covering element may include a plate-like element with thickness and whereas said one or more apertures provided in said plate-like element have width, and when said printing unit is placed at said predefined distance from said printing plane a distance between the external surface of said covering element and said printing plane is defined, as well as a distance between a point of incidence, nearest to said print head, of said light rays on said printing plane and the end of said one or more apertures nearest to said at least one light source is defined, said thickness and said width being sized so that their ratio is higher than the ratio.

According to an embodiment of the present application, the printing unit may include at least two light sources for each of which said distance is defined, said thickness and said width being sized so that the value of their ratio is higher than the biggest of the ratios of said at least two light sources.

According to an embodiment of the present application, the printing unit may include a single light source.

According to an embodiment of the present application, said printing surface may substantially extend along a longitudinal direction and said plurality of nozzles are distributed on said printing surface along one or more rows parallel to each other and to said longitudinal direction, and said covering element may be provided with a number of apertures with substantially longitudinal development that is equal to the number of said rows of plurality of nozzles present on said printing surface in order to allow said ink to be ejected through said plurality of nozzles towards the printing plane and to prevent said light rays from directly hitting said printing surface.

According to an embodiment of the present application, said covering element may be removably arranged so that it rests on and covers said printing surface through coupling members suited to be reversibly coupled with said print head.

According to an embodiment of the present application, said coupling members may include a frame defining in its inside a window in which said covering element is removably fitted, said frame being configured so that it can be removably fitted in a housing defined in said print head, in such a way that said covering element with its internal surface is arranged so that it rests on and covers said printing surface.

According to an embodiment of the present application, said removable coupling between said frame and said print head may be obtained through magnetic members.

According to an embodiment of the present application, said magnetic members may be arranged in said housing defined in said print head and said frame may be made of a ferromagnetic material.

According to an embodiment of the present application, at each one of the two short sides of said window, on the side of its external surface, said frame may be provided with a recess configured so as to accommodate one of the two short sides of said covering element, said frame also including on said external surface, at the two long sides of said window, two projections facing towards the inside of said window and defining reference surfaces that are on the opposite side with respect to the external surface and configured so as to limit the extension of said covering element beyond the plane defined by said external surface. According to an embodiment of the present application, said covering element may have, along its long sides, two recesses suited to be coupled with said projections of said frame, said recesses and said projections being sized so that when said covering element is fitted in said frame the overall thickness defined by each recess with the corresponding projection is substantially equal to the thickness of said covering element. In another aspect of the present application, a printing system of the type that uses liquid ink for printing on the surfaces of printed circuit boards is provided. The printing apparatus may include a printing unit according to any of the embodiments of the present application.

### BRIEF DESCRIPTION OF DRAWINGS

So that the manner in which the above recited features of the present application can be understood in detail, a more particular description of the application, briefly summarized above, may be had by reference to embodiments. The accompanying drawings relate to embodiments of the present disclosure and are described in the following:
- Figure 1a and 1b are side views of a printing unit;
- Figure 1c is a schematic view of an ink drop landing on a surface;
- Figure 2 is a schematic top plan view of embodiments of a printing unit for printing on a substrate;
- Figure 3 is a schematic view of further embodiments of a printing unit for printing on a substrate;
- Figure 4 is a schematic view of yet further embodiments of a printing unit for printing on a substrate;
- Figure 4a is a detail of embodiments of a printing unit for printing on a substrate;
- Figure 5 is a perspective view of embodiments of a printing unit for printing on a substrate;
- Figure 6 is a further perspective view of embodiments of a printing unit for printing on a substrate;
- Figures 7 and 8 are side views of a printing unit according to embodiments of the application;
- Figure 9 is an axonometric view of a print head to which a covering element according to embodiments of the application is applied;
- Figure 10 is an axonometric exploded view of a print head and a covering element according to embodiments of the application;
- Figure 11 is a front view of the printing surface of a printing unit according to embodiments of the application;
- Figure 12 is front view of the covering element of the printing unit according to embodiments of the application;
- Figure 13 is an axonometric view of the external surface of the frame belonging to a printing unit according to embodiments of the application;
- Figure 14 is an axonometric view of the inner surface of the frame described using in Figure 13;
- Figure 15 is a cross-sectional axonometric view of the frame described using in Figure 13 coupled with a mask according to embodiments of the application;
- Figure 16 is a cross-sectional view of the frame described using Figure 15 coupled with a mask, according to embodiments of the application, according to a plane parallel to the longitudinal axis α of said frame;
- Figure 17 is a cross-sectional view of the frame described using Figure 15 coupled with a mask, according to embodiments of the application, according to a plane orthogonal to the longitudinal axis of said frame; and
- Figures 18 is a side view of a printing unit according to further embodiments of the application with respect to that described using Figure 7.

### DETAILED DESCRIPTION

Reference will now be made in detail to the various embodiments of the application, one or more examples of which are illustrated in the figures. Within the following description of the drawings, the same reference numbers refer to the same components. Generally, only the differences with respect to individual embodiments are described. Each example is provided by way of explanation of the present disclosure and is not meant as a limitation thereof. For example, features illustrated or described as part of one embodiment can be used on or in conjunction with other embodiments to yield yet a further embodiment. It is intended that the present disclosure includes such modifications and variations. Embodiments described herein may refer to a printing unit 1, particularly for ink-jet printing on a substrate 100, and to a printing apparatus 60 including such printing unit 1.

Further embodiments described herein may refer to a method for printing on a substrate 100, particularly for ink-jet printing on a substrate 100.

It is noted here that a substrate as used within the embodiments described herein can be at least one element selected from a group consisting of: an electronic substrate, a panel, a laminate, a sheet, a conductive metal sheet, a conductive metal sheet laminated onto a nonconductive support, a print circuit board (PCB), a single layer PCB, a double-layer PCB, a multi-layer PCB, a flat panel display (FPD), a conductive material, a conductive material with a silicon or alumina base, a plate, a wafer, a foil, a semiconductor wafer, and similar articles or items, for instance to form PCB's, FPD's, green-tape electronic circuits, or the like. An example of conductive metal can be for instance copper. For example, PCBs or FPDs can be provided as a substrate. Therefore, some embodiments described herein can be used for example to print PCBs or FPDs.

Embodiments of the present disclosure can be used for printing on a substrate 100, in one or more of the following applications:
- legends and marking (e.g. serialization, barcodes, data matrix, not good marking and other similar information) on PCB, in particular rigid or flexible PCB;
- etch resist for PCB, smart cards, antennas, foil heaters and similar articles;
- solder resist for PCB and IC (integrated circuit) substrates;
- underfill dams for IC substrates
- dams for molding on IC substrates
- dams for light emitting diodes (LEDs)
- legends and marking (serialization, barcodes, data matrix, not good marking and other similar information) over ICs and IC molding;
- touch screen conductors;
- metal etching.

In particular, some embodiments described herein can be used as printing unit and printing apparatus which are capable of printing high resolution images in one single pass, i.e. images which have resolution equivalent to images obtainable by two low resolution images printing passes printed with one single print head.

In general, according to the present disclosure, a printing unit and a printing apparatus, and a relative printing method, can be provided which are capable of printing a high resolution image which is equivalent to three, four, five or even more than five printing passes performed by one single print head.

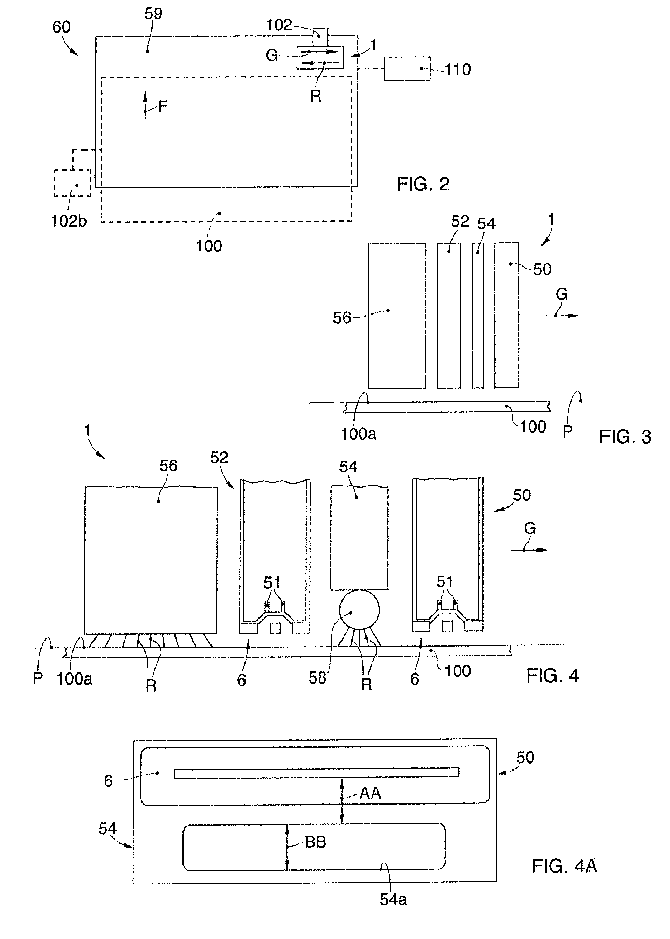

A surface of the substrate 100 receiving ink jet printing can be denoted by numeral reference 100a (see e.g. Figure 3) and can define a printing plane P, i.e. a plane along which the printing operation can be performed. In particular, a legend, e.g. including variable data such as text or bar code with a serial number, can often be printed on one or both sides of the PCBs, for instance containing the component designators, switch settings, test points and other indications helpful in assembling, testing and servicing the circuit board. Some embodiments described herein can be used for example to print legend(s) on PCBs.

Therefore, embodiments described herein may provide a printing apparatus and a method of operating thereof, for example, to achieve legend(s) on a substrate 100, e.g. a PCB.

Figure 2 is used to describe a plurality of embodiments, which can be combined with all embodiments described herein, of a printing apparatus 60 for printing on substrate(s) 100 including at least one printing unit 1 according to the present disclosure.

According to embodiments, the printing apparatus 60 can include a printing substrate support 59 configured for supporting the substrate 100 to be printed, such as to define the above mentioned printing plane P (see e.g. Figures 2 and 3).

For example, and not limited to any embodiment, the printing substrate support 59 can be used for supporting the substrate during a printing process. A substrate support as used in embodiments described herein can be a flat plate, a portion of a transport system, a substrate holder, a pedestal or other support for supporting the substrate.

The printing substrate support 59 thereby can include at least one of: a transfer mechanism, actuation member(s) 102a, 102b, a disposable substrate receiving surface, a substrate receiving surface feeding mechanism, a driving mechanism, an optical transparent substrate receiving surface, a substrate fixation, e.g. a clamp, an underpressure unit, a vacuum suction device, a retractable fixation device or the like, for example for holding/retaining the substrate 100 on the printing substrate support 59 at least during the execution of one or more operations of a printing process.

According to typical implementations, a combination of vacuum, clamps and retractable bridges can be used for completely flatten the printing area of the substrate 100, to ensure the highest quality printing on a variety of panel thicknesses.

Actuation member(s) 102a, 102b (see e.g. Figure 2) can be provided, which can be configured for performing a movement of the printing unit 1 and/or of the substrate 100, i.e. a relative movement of the printing unit 1 with respect to the substrate 100, in particular a linear movement which can be the result of two combined linear movements along a plane parallel to a printing plane P.

Typically, actuation member(s) 102a and/or 102b can be configured to move, e.g. progressively, step-by-step, continuously or quasi-continuously, respectively the printing unit 1 and/or the substrate 100. Typically, actuation member(s) as used in implementations of the embodiments described herein can be configured for actuating an X-Y movement, i.e. along a pair of mutually orthogonal axis, of the printing unit 1 and/or of the substrate 100, for instance on an horizontal plane. The actuation member(s) according to possible embodiments can be actuator(s), for instance linear actuator. Linear actuators which can be used in embodiments described herein may include one motor selected from a group consisting of: an electrical motor, a pneumatic motor, a hydraulic piston, a piezoelectric actuator. Usually, a linear actuator as used in combination with all embodiments described herein can be an intrinsically linear motion actuator or be configured to convert a circular motion into linear motion. Conversion can be commonly made via types of mechanism selected from a group consisting of: screw actuators, like a screw jack, a ball screw and a roller screw actuators, or wheel and axle, e.g. drum, gear, pulley or shaft, actuators, like a cable hoist, a winch, a rack and pinion assembly, a chain drive, a belt drive, rigid chain and rigid belt actuators.

The substrate 100 may be introduced along a feed direction on the printing substrate support 59 (see arrow F in Figure 2, e.g. Y-axis). Introduction of the substrate 100 can be performed progressively, continuously, quasi-continuously, step-by-step. In possible implementations, the printing unit 1 can be configured to be movable along a printing direction (see arrow G in Figure 2, e.g. X-axis), which is typically transverse, e.g. orthogonal, to the feed direction F. Typically, the printing unit 1 can be moved in a first run along the printing direction G, e.g. in a direction from left to right, from a start position to an end-of-printing position, to perform the printing operation or process. Then, the printing unit 1 can be moved back in a second run along a return direction (see e.g. arrow R on Figure 2), to reach again the start position and the repeat the process.

Typically, once the substrate 100 is introduced a desired amount into the printing substrate support 59, the printing unit 1 can be moved to perform a printing operation along a portion, e.g. a band, of the substrate 100, along the afore-mentioned printing direction G. During printing of such portion, or band, the substrate 100 can be in a stop condition, while the printing unit 1 can be transversally displaced along the printing direction G. Once printing along a portion, or band, of the substrate 100 is completed, the printing unit can be moved back, along the return direction R, and the substrate 100 can be made to advance a further amount inside the printing substrate support 59 along the feed direction F and the same printing operation is repeated, until the whole printing operation is performed on the substrate 100.

According to embodiments, the printing unit 1 can be positioned above the printing plane P, for instance at a fixed distance, or height, with respect to the printing plane P on the substrate 100. In some implementations, the fixed distance between the printing unit 1 and the printing plane P can be selected in a range of between 0.5 - 2 mm. According to different or other embodiments, the printing unit 1 can be positioned above the printing plane P at an adjustable, or variable, distance, or height, with respect to the printing plane P on the substrate 100, for example in a range of between 0.5 - 2 mm.

In some possible implementations, the afore-mentioned actuation member(s) 102b providing the printing unit 1 with horizontal movement, e.g. along X-Y axis, can be further configured to provide the printing unit 1 with a vertical movement to vary distance, or height, with respect to the printing plane P, e.g. a movement along a Z-axis orthogonal to the X and Y axis.

In yet further possible implementations, the afore-mentioned actuation member(s) 102a which can provide the substrate 100 with horizontal movement, e.g. along X-Y axis, can be further configured to provide the substrate 100 with a vertical movement to vary distance, or height, with respect to the printing unit 1, e.g. a movement along a Z-axis orthogonal to the X and Y axis.

Figures 3, 4, 5 and 6 are used to describe embodiments of a printing unit 1 according to the present disclosure.

According to embodiments, the printing unit 1 can include two print heads, in particular a first print head 50 and a second print head 52. According to possible implementations and/or to generalization of the embodiments described herein, a printing unit 1 according to the present disclosure can include more than two print heads, for instance three, four, five or even more than five print heads, in order to print a high resolution image which is equivalent to an image obtained by three, four, five or even more than five printing passes performed by one single print head.

According to possible implementations of the embodiments described herein, the print heads, e.g. first print head 50 and second print head 52, which can be used according to the present disclosure can be ink-jet print heads, that is print heads provided with a plurality of nozzles 51, configured for ink-jetting. For example, each of the first print head 50 and second print head 52 can be provided with one or more rows of nozzles 51 whereby ink can be jetted. For instance, each row of nozzles can include tens or hundreds of nozzles configured for ink jetting, or ink-jet nozzles, for example 512 nozzles.

According to the present disclosure, ink that can be jetted by the print heads is a UV curable ink, or UV-sensitive ink, or UV ink.

According to the present disclosure, the printing unit 1 includes a UV pinning light source 54 interposed between the first print head 50 and the second print head 52. In other words, between two adjacent print heads, such as first print head 50 and second print head 52, a UV pinning light source 54 is interposed. Such UV pinning light source 54 is configured to provide pinning of the ink drop from the first print head 50 before the ink drop from the second print head 52 arrives.

By providing a UV pinning light source 54 between the first print head 50 and the second print head 52, may prevent the adverse effect of two ink drops merging in a single big drop and/or the first drop be deformed and moving out of its correct position and also the second one doing the same.

In fact, pinning of the ink drop jetted for instance by the first print head 50, i.e. exposing the first ink drop with enough UV energy to perform the phase transition before the second overlapping ink drop from the second print head 52 arrives, has the effect to "freeze", i.e. to "gel" such first drop of ink on the surface, before it has time to spread out. In this way, the two drops can maintain their original shape and position.

Therefore, UV pinning may enhance the management of drop size and image integrity, minimizing the unwanted mixing of drops and providing the highest possible image quality and the sharpest colour rendering. Pinning ink drops stops the drops from spreading, however leaving the ink flexible and soft enough for proper inter-coat adhesion to other ink droplets and for further handling. Full or final curing can occur at the end of the process and transforms the ink onto a more rigid film with the required final surface properties. Generally, all pinned inks should still pass underneath a final cure UV source to be fully cured.

According to possible implementations and/or to generalization of the embodiments described herein, a printing unit 1 according to the present disclosure can be provided which can include more than two print heads, for instance three, four, five or even more than five print heads, as described above, and can also include a plurality of respective UV pinning light source, each interposed between each pair of adjacent print heads, i.e. a UV pinning light source interposed between a first print head and a second print head, a further UV pinning light source between the second print head and a third print head, a possible still further UV pinning light source between the third print head and a fourth print head, yet a possible further UV pinning light source between the fourth print head and a fifth print head, and so on. This configuration can be provided, as above discussed, in order to print a high resolution image which is equivalent to an image obtained by three, four, five or even more than five printing passes performed by one single print head. According to the present disclosure, the printing unit 1 can further include a UV curing light source 56 disposed on an outer side of one or the other of the first print head 50 and second print head 52. For example, the UV curing light source 56 can be disposed on an outer side of the second print head 52.

According to possible implementations and/or to generalization of the embodiments described herein, a UV curing light source 56 can be disposed at the end, or downstream, a series of print heads and respective interposed UV pinning light sources as described above for a printing unit provided with more than two print heads, for instance three, four, five or even more than five print heads, and also provided with a plurality of respective UV pinning light sources, each interposed between each pair of adjacent print heads.

Embodiments described herein, which can be combined with other embodiments described herein, may provide a method for printing on a substrate 100 that for instance can be performed using the printing apparatus 60. According to some embodiments described herein, the method includes executing a first printing operation on the substrate 100, followed by a UV pinning, by a second printing operation and by a UV curing afterward.

In some possible implementations, a UV light source that can be used as a UV pinning light source 54 or a UV curing light source 56 can be a light or radiation source manufactured to emit light in the ultraviolet range (i.e. between 10 nm and 420 nm), which for instance can be selected from a group consisting of fluorescent lights, fluorescent black lights, short wave ultraviolet lamps, laser, ultraviolet laser, ultraviolet gas laser, high power gas laser, e.g. nitrogen gas laser or excimer laser, UV laser diodes, UV solid-state lasers, electron beam, illuminator, a monochromatic light source, light emitting diode (LED), LED array, ultraviolet LEDs, gas discharge lamps, argon and deuterium lamps, Hg-Cd lamp, arc lamp, electric arc lamp, flash lamp, Xe or halogen lamp, or any other suitable source.

According to different implementations of the embodiments described herein, a UV lamp device can be an example of a UV light source, or a UV lamp, e.g. a UV LED device which can, for instance, encapsulate LEDs, arrays, optics and a possible cooling system.

According to possible implementations, the UV pinning light source 54 and the UV curing light source 56 can be UV LED devices which can be suitably configured in order to respectively perform pinning, i.e. UV pinning LED device, and curing, i.e. UV curing LED device.

According to possible implementations of the embodiments described herein, a suitable UV pinning LED device can have a total UV power, i.e. an irradiance at UV emitting window, of between 0.1 W/cm² to 6W/cm², in particular between 0.5W/cm² and 2W/cm², for instance 0.5W/cm², 0.75W/cm², 1W/cm², 1.5W/cm² and 2W/cm² or even more.

According to possible implementations of the embodiments described herein, a suitable UV pinning LED device can have a width BB of an active emitting window 54a of between 2 mm to 20 mm, for instance 2.5 mm, 5 mm, 7.5 mm, 10 mm, 15 mm or even more (see e.g. Figure 4a). According to possible implementations of the embodiments described herein, a suitable UV pinning LED device can have a UV output, or pure UV output, i.e. an operative UV wavelength range, of between 365-420nm, for example 365-405 nm, with a peak at 395 nm, or a peak between 365-405 nm or with multiple peaks between 365-405 nm, for instance by using a combination of different LED emitters.

According to possible exemplary implementations, a suitable UV pinning LED device can have the following properties: an irradiance at UV emitting window of 1W/cm², an emitting window of 75x5mm, a total UV power up to 3.75W and a UV output of between 380-420nm.

According to other exemplary implementations, another suitable UV pinning LED device can have the following properties: an irradiance at UV emitting window of 2W/cm², an emitting window of 75x10mm or 110x10, a total UV power up to 22W and a UV output of between 380-420nm.

According to possible implementations of the embodiments described herein, the UV pinning light source 54 can be disposed at a distance from the first print head 50 of between 5 mm to 50 mm, for instance 10 mm. It is noted here that a distance between the UV pinning light source 54 and the first print head 50 can be considered as a distance AA (see e.g. Figure 4a) measured from an inner edge of a nozzle covering plate of the print head and an outer edge of the emitting window 54a of the UV pinning light source 54.

Examples of UV pinning light sources readily available on the market are for instance UV pinning LED device from Phoseon Technology, Inc., such as FireEdge™ series, e.g. FireEdge™ FE200 or FireEdge™ FE300, or from Integration Technology Ltd., such as LEDZero series, e.g. Pincure, Pincure Plus, VTwin, VTwin plus.

According to possible implementations of the embodiments described herein, the UV pinning light source 54 can be optionally provided with Angle Reduction Technology (ART) optics, by which for instance provide specific application pinning or curing performance. One or more collimation lenses 58 (see e.g. Figure 3) can be an example of ART optics. An ART rod or ART rod lens, e.g. a quartz rod, can be a further example of a collimation lens 58, or a cylindrical collimation lens, or a cylindrical lens. An ART rod can minimize the effects of stray UV light by reducing the emitting angle. The ART rod lens can be configured to maximize the peak irradiance away from the glass surface at a working distance of, e.g. 5 to 10 mm, and yields the highest peak irradiance.

In some possible implementations, the ART optics, e.g. the afore-mentioned one or more collimation lenses 58, are typically disposed underneath the UV pinning light source 54, i.e. between the UV pinning light source 54 and the printing support 59. During use, the ART optics are therefore disposed between the UV pinning light source 54 and the printing plane P defined by the surface 100a of the substrate 100.

When pinning UV ink, peak irradiance, total energy (dose), and dwell time may affect the pinning process. Since the working distance from the UV source to the material surface should be considered to ensure optimum results, according to possible implementations of the embodiments described herein, the lower edge of the collimation lens 58 can be typically at the same level as the level of the lower surface of the first print head 50, with a tolerance of about 1 mm. However, other implementations may provide that the UV pinning light source 54, and therefore the collimation lens 58, are arranged at a higher level than the lower surface of the first print head 50, for instance up to 50 mm higher. According to possible implementations of the embodiments described herein, a suitable UV curing LED device can have an irradiance at UV emitting window of between 3W/cm² and 10W/cm², in particular between 4W/cm² and 5W/cm², for instance 3W/cm², 3.5W/cm², 4W/cm², 4.5W/cm² and 5W/cm² or more.

According to possible implementations of the embodiments described herein, a suitable UV curing LED device can have a width of between 15 mm to 60 mm, in particular 20 mm to 55 mm, more in particular 25 mm to 50 mm, for instance 15 mm, 20 mm, 25 mm, 30 mm, 35 mm, 40 mm, 45 mm, 50 mm or even more.

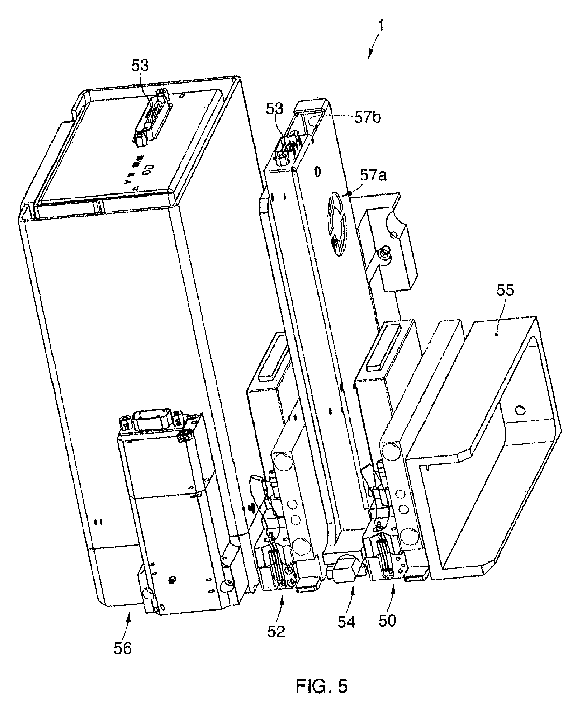

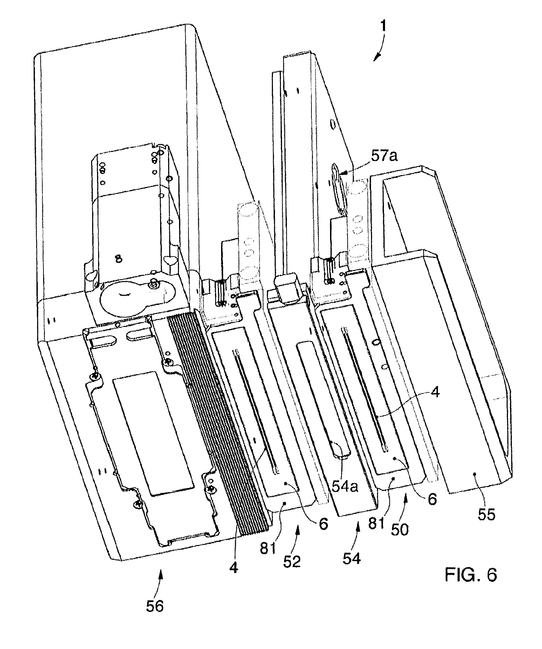

According to possible implementations of the embodiments described using Figures 5 and 6, the UV pinning light source 54, as well as the UV curing light source 56, can be provided with Data and a DC power connector 53. The UV pinning light source 54 can also be equipped with a cooling system which can be for instance an air cooling system, e.g. including an air inlet 57a and an exhaust air outlet 57b. According to implementations, the UV pinning light source 54 can be mounted adjacent to both the first print head 50 and the second print head 52, so as to be in contact on both sides with them, for instance by using a mounting system, e.g. a set of mounting holes or other similar mounting members, provided in the same UV pinning light source 54. In a similar manner, the UV curing light source 56 can be mounted adjacent at the outer side of the second print head 52.

A shield member 55 can be provided (see e.g. Figures 5 and 6) for protecting the other components of the printing unit 1 from mechanical damages in case the printing unit 1 accidentally hits the substrate 100 during the printing motion. The shield member 55 can be mounted for instance on an outer side of the first print head 50.

In possible implementations, each of the first print head 50, second print head 52, UV pinning light source 54, UV curing light source 56 and possible shield member 55 can be independently mounted and fixed to a back plate of the printing unit 1 (not visible in the drawings), which can be in turn attached to the apparatus 60 by a connection element, such as a vertical connection element, i.e. by a Z-axis connection element.

Figure 3 is used to illustrate yet further embodiments, which can be combined with further embodiments described herein, in which the printing apparatus 60 can include a system controller 110, e.g. a control unit.

Possible embodiments of the system controller 110, e.g. control unit, can be used to facilitate the control and automation of the overall printing apparatus 60 and may include at least one of element selected from a group including: a central processing unit (CPU) (not shown), memory (not shown), and support circuits (or I/O) (not shown). For example, the CPU may be one of any form of computer processors that can be used in industrial settings for controlling various chamber processes and hardware (e.g., conveyors, optical inspection assemblies, motors, fluid delivery hardware, etc.) and monitor the system and chamber processes (e.g., substrate position, process time, detector signal, etc.). The memory can be connected to the CPU, and may be one or more of a readily available memory, such as random access memory (RAM), read only memory (ROM), floppy disk, hard disk, mass memory, flash memory or any other form of digital storage, local or remote, e.g. cloud data storage. Software instructions and data can be for example coded and stored within the memory for instructing the CPU. The support circuits can be also connected to the CPU for supporting the processor in a conventional manner. The support circuits may include for example at least one of: cache, power supplies, clock circuits, input/output circuitry, subsystems, and the like. A program (or computer instructions) readable by the system controller 110 can determine which tasks are performable on a substrate. In some embodiments, the program is software readable by the system controller 110. The system controller 110 includes code to generate and store at least substrate positional information, the sequence of movement of the various controlled components, e.g. of the printing unit 1 and/or of the substrate 100 and/or of the printing substrate support 59 and any other corresponding combination.

Embodiments of a method for printing on a substrate as described herein can be included in a computer program memorizable in a mean readable by a computer that contains the instructions which, when carried out by the system controller 110, determine the execution of the printing method by a printing apparatus 60.

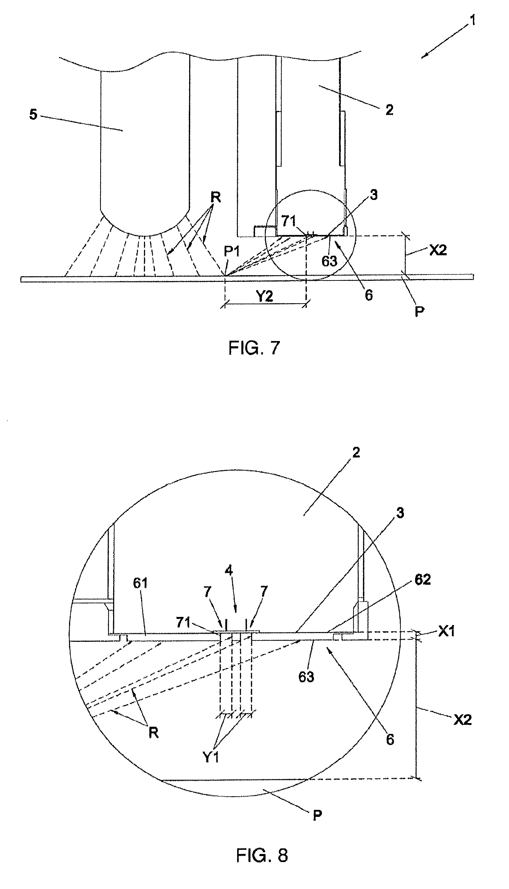

Figures 7, 8, 9, 10, 11, 12, 13, 14, 15, 16 and 17 are used to describe yet further embodiments of a printing unit 1 according to the present disclosure, combinable with all embodiments described herein, including one print head 2 provided with a printing surface 3, on which there is a plurality of nozzles 4, through which the ink is ejected typically in the form of drops.

It cannot be excluded, however, that in a different embodiment of the application the printing unit 1 includes more than one print head 2.

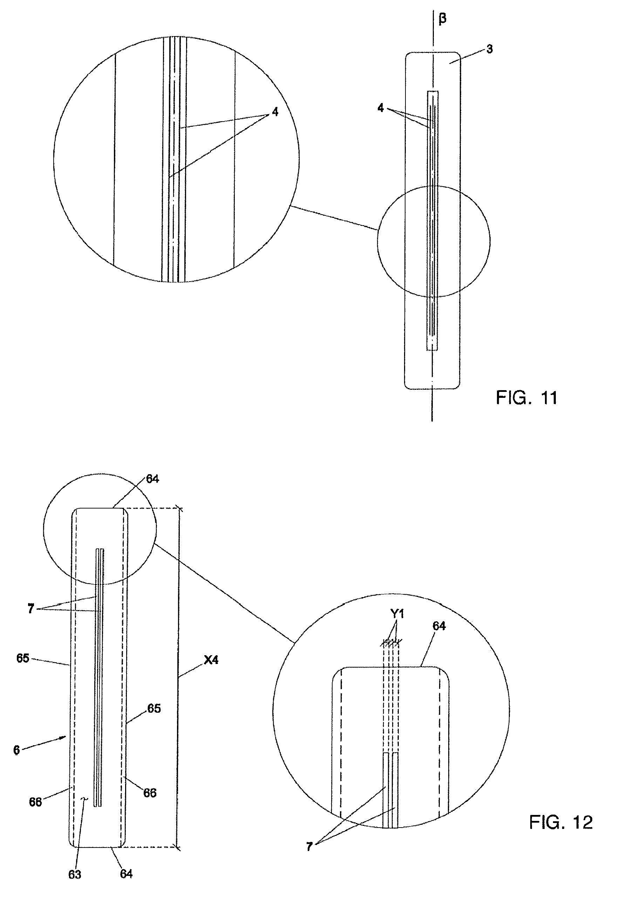

According to embodiments of the application, printing surface 3 extends in a substantially longitudinal direction β and plurality of nozzles 4 can be distributed in two parallel rows that are also parallel to longitudinal direction β, as shown in Figure 11.

According to other embodiments of the printing unit 1 of the application, not shown herein, plurality of nozzles 4 are distributed in a single row parallel to the longitudinal direction β of the printing surface 3.

It cannot be excluded, however, that in alternative embodiments of the application the plurality of nozzles 4 can be arranged on the printing surface 3 in a different way from that envisaged in the two embodiments described above.

As can be described using Figure 7, the printing unit 1 of the application can also include one light source 5 that is integrally coupled with the print head 2.

Also in this case, it cannot be excluded, however, that in an alternative embodiment of the application the printing unit 1 includes more than one light source 5.

According to embodiments of the application, said light source 5 can be configured so that it emits light rays R at UV wavelengths, that is, capable of polymerizing the UV-sensitive ink ejected by the plurality of nozzles 4 of the print head 2.

In an embodiment of the application, light source 5 may be configured so that it emits light rays R at wavelengths different from UV wavelength, provided that they can solidify the liquid ink used for printing, for instance IR sintering.

Regarding the printing unit 1 of the application in general, instead, as mentioned previously and as shown in Figure 7, this may be configured so that it can be arranged at a predefined distance from the printing plane P on which the printing operation is carried out, with printing surface 3 and light source 5 oriented towards the same printing plane P.

The printing unit 1 may be, furthermore, configured to move with respect to the printing plane P along two directions X and Y orthogonal to each other and parallel to the same printing plane P.

According to implementations of the embodiments described herein, (see e.g. Figures 7 and 8), the printing unit 1 may include a covering element 6 arranged with an internal surface 62 thereof resting on and covering printing surface 3 of print head 2. For example, a covering element as used in embodiments described herein can have a thickness of between 0.1 - 0.5 mm, in particular 0.2 - 0.4 mm, for instance 0.3 mm.

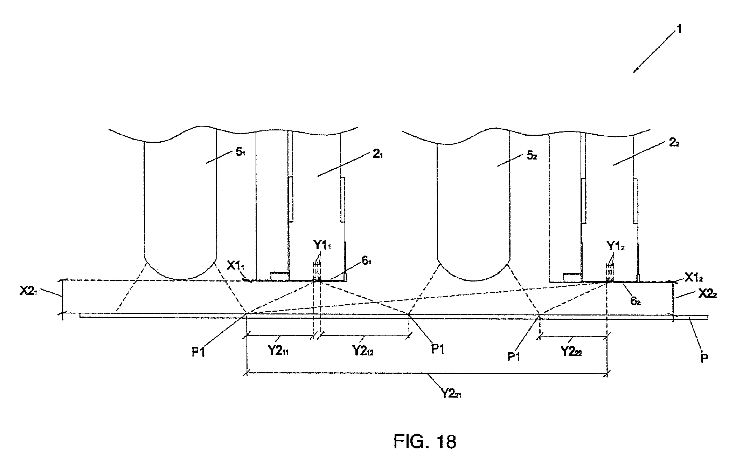

It cannot be excluded, however, that in other embodiments of the application, according to which the printing unit 1 is provided with more than one print head (see e.g. Figures 3, 4, 5, 6 and 18), the printing unit 1 includes more than one covering element 6, each of which is arranged with its internal surface 62 resting on and covering a printing surface 3 of one of said print heads.

Moreover, it cannot be excluded, that in yet further embodiments of the application, always according to which the printing unit 1 is provided with more than one print head 2, the printing unit 1 includes one single covering element 6 which covers the printing surfaces 3 of said print heads 2.

Figure 12 is used to illustrate yet further embodiments, which can be combined with further embodiments described herein, in which the covering element 6 can be provided with two apertures 7 shaped in such a way as to allow the ink to be ejected through the plurality of nozzles 4 and apertures 7 towards the printing plane P.

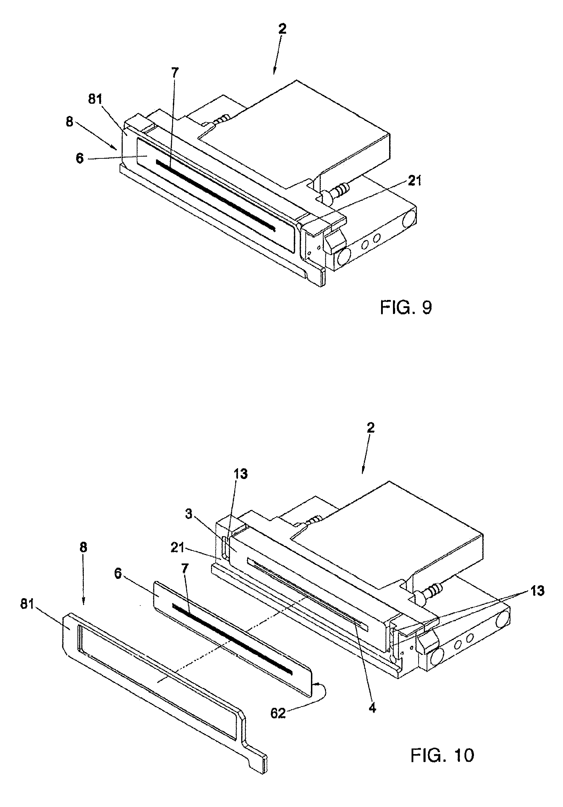

In particular, according to embodiments of the application, the two apertures 7 can extend along a longitudinal direction and for instance can be parallel to each other, in such a way as to be superimposed, i.e. aligned, to the two rows of the plurality of nozzles 4 when the covering element 6 is arranged so that it rests on said printing surface 3, as shown in Figures 8 and 9.

Advantageously, in still further embodiments the printing system can include the printing unit 1 according to the present disclosure and also a cleaning station, e.g. of the known type. In some implementations according to such embodiments, the shape of the two apertures 7 allows the same cleaning station to produce a sufficient air suction on the printing surface 3, capable of effectively cleaning the plurality of nozzles 4 notwithstanding the presence of the covering element 6.

It cannot be excluded, however, that in further embodiments of the application the number and shape of said apertures 7 can be different from those described according to the preferred embodiment shown in Figure 12, provided that said apertures 7 are configured so as to allow the ink to be ejected through the plurality of nozzles 4 towards the printing plane P.

According to yet further embodiments schematically described for example in Figure 8, the covering element 6 and the apertures 7 can also be sized in such a way as to prevent the light rays R emitted by the light source 5 and reflected by the printing plane P from passing through said apertures 7 and directly hitting the printing surface 3.

In particular, according to possible implementations of the embodiments described herein, the thickness X1 of the plate-like element 61, or nozzle covering plate or nozzle plate, that makes up the covering element 6 and the width Y1 of the apertures 7 are sized in order to prevent light rays R from hitting the printing surface 3, as explained below.

According to possible implementations, it should be firstly noticed that during the setting of a printing system it is possible to identify some distances related to the mutual position of the printing unit 1 and the printing plane P, which remain substantially constant for the entire operating cycle of said system. In fact, when the printing unit 1 of the application is arranged at said predefined distance from the printing plane P, it is possible to define a first fixed distance X2 between the external surface 63 of the covering element 6 and said printing plane P and a second fixed distance Y2 between the incidence point P1, nearest to the print head 2, of the light rays R on the printing plane P, as shown in Figure 7, and the end 71 nearest to the light source 5 of the aperture 7, in turn nearest to said light source 5.

According to embodiments of the application the thickness X1 and the width Y1 are sized so that the value of their ratio X1/Y1 is higher than the value of the ratio between first distance X2 and second distance Y2. This configuration of the covering element 6 thus makes it possible to substantially prevent the light rays reflected by the printing plane P from reaching the printing surface 3 where the plurality of nozzles 4 is located, as schematically shown in Figure 8.

This ratio between the dimensions of the covering element 6 and the position of the printing unit 1 of the application with respect to a printing plane P can remain valid also for embodiments of the application, according to which the plurality of nozzles 4 is arranged in a different way on the printing surface 3 and, consequently, the number and shape of the apertures 7 differ from those described up to now. Moreover, this ratio between the dimensions of the covering element 6 and the position of the printing unit 1 of the application with respect to a printing plane P can remain valid also for embodiments of the application, according to which the printing unit 1 includes more than one print head 2 and for instance more than one covering element 6 or includes more than one light source 5.

In particular, in embodiments in which the printing unit 1 includes two light sources 5₁ and 5₂ and only one print head 2, if X2/Y2₁ is the ratio of distances for the first light source 5₁ and X2/Y2₂ is the ratio for the second light source 5₂, then the thickness X1 and the width Y1 of the covering element 6 are sized so that the value of their ratio X1/Y1 is higher than the biggest one between the ratios X2/Y2₁ and X2/Y2₂.

Furthermore, in embodiments in which, as described using for instance Figures 3, 4, 5, 6 and 18, the printing unit 1 can include two print heads 2₁ and 2₂ which can be provided for instance with two respective covering elements 6₁ and 6₂ and also in which the printing unit 1 can include two light sources 5₁ and 5₂, then the thickness X1₁ and the width Y1₁ of the first covering element 6₁ are sized so that the value of their ratio X1₁/Y1₁ is higher than the ratio with the biggest value X2₁/Y2₁₁, and therefore it is higher than the ratio X2₁/Y2₁₂, whereas the thickness X1₂ and the width Y1₂ of the second covering element 6₂ are sized so that the value of their ratio X1₂/Y1₂ is higher than the ratio with the biggest value X2₂/Y2₂₂, and therefore it is higher than the ratio X2₂/Y2₂₁. This concept can be generalized, with respect to that described with reference to Figures 3, 4, 5, 6 and 18, to any number of print heads 2ᵢ and any number of light sources 5ⱼ: the thickness X1ᵢ and the width Y1ᵢ for each covering element 6ᵢ are sized so that the value of their ratio X1ᵢ/Y1ᵢ is higher than the biggest one of the ratios X2ᵢ/Y2ᵢⱼ, where Y2ᵢⱼ is the distance between the end 71 of the i-th covering element 6 and the point of incidence P1 of the light rays R of the j-th light source 5.

Obviously, the end 71 of aperture 7 and the same aperture 7 of each covering element 6ᵢ have to be chosen on the left or on the right so that they are always the closest ones to light source 5ⱼ and the same applies to the point of incidence P1 which has to be always the closest one to the print head 2ᵢ.

According embodiments of the application, the covering element 6 can be preferably but not necessarily arranged so that it rests on and covers the printing surface 3 in a removable manner, through coupling members 8 configured so as to be reversibly coupled with the print head 2.

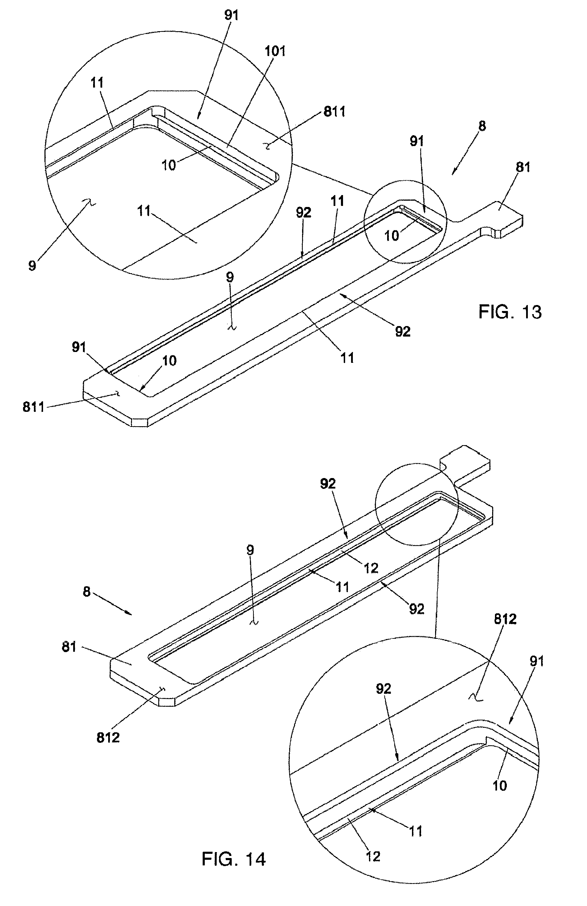

In particular, according to embodiment of the application described for example with reference to Figures 13 and 14, coupling members 8 can include a frame 81 defining in its inside a window 9 into which covering element 6 can be inserted and fitted in a removable, i.e. releasable, manner.

The same frame 81 can be in turn configured so that it can be removably fitted in a housing 21 shaped for this purpose in print head 2, as shown in Figures 9 and 10, so that covering element 6, with its internal surface 62, is arranged so that it rests on and covers printing surface 3.

This configuration can allow two important advantages to be achieved.

A first advantage, as mentioned before, lies in the possibility to remove the covering element 6 from the printing surface 3, allowing it to be replaced after a given time period and making it possible to carry out an extraordinary cleaning operation on printing surface 3.

A second advantage resulting from said configuration consists in the optimal coupling of the covering element 6 resting on the printing surface 3. Consequently, it is possible to maintain the distance between the printing surface 3 and the printing plane P substantially unchanged. This characteristic can be of a fundamental importance, as the desired printing accuracy depends on said distance.

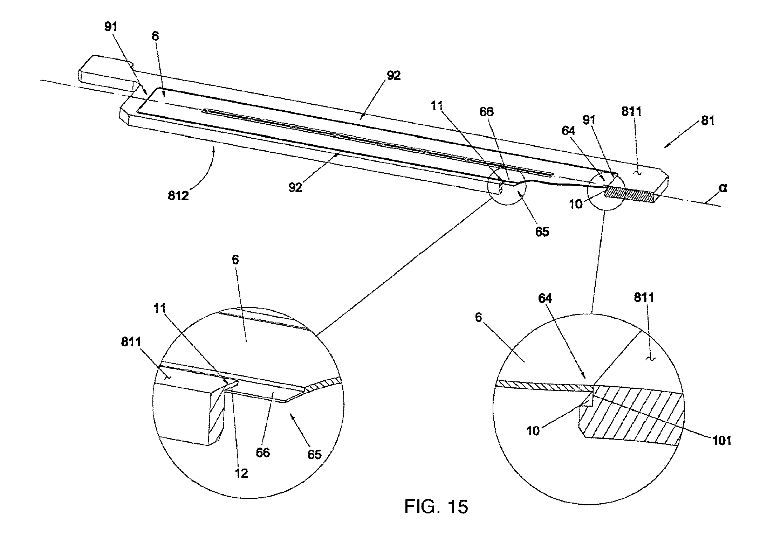

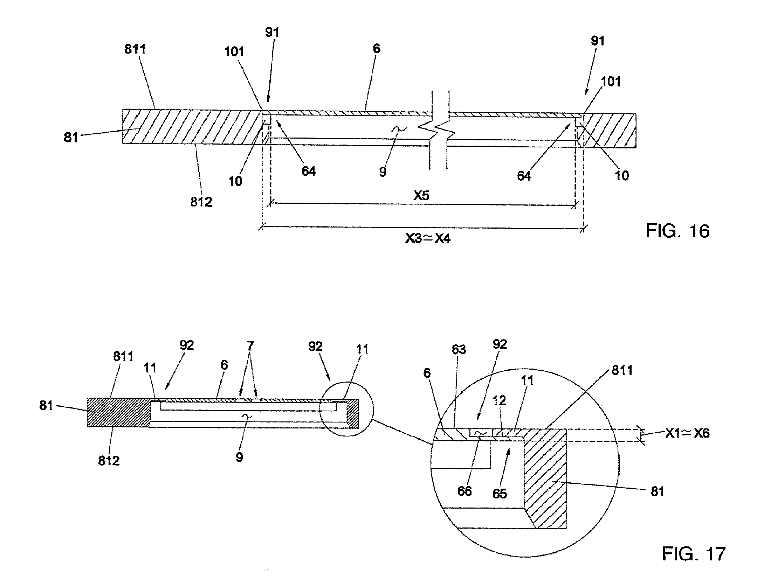

In particular, in accordance with embodiments of the application, these advantages can be obtained thanks to a particular configuration of the frame 81, described for instance with reference to Figures 13 and 14. According to this embodiment, the frame 81, at each one of the short sides 91 of the window 9, on the side of its external surface 811, includes a recess 10 configured so that it can accommodate one of the two short sides 64 of covering element 6, as described for instance with reference to Figure 15. Figure 16 is used to illustrate embodiments, which can be combine d with all embodiments described herein, in which the covering element 6 is installed within frame 81, according to a cross-section plane parallel to the longitudinal axis α of the frame 81 described with reference to Figure 15.

In the embodiment described with reference to Figures 15 and 16 external surface 811 is on the opposite side with respect to the inner surface 812 of the frame 81 configured to be facing towards the surface of said housing 21 of the print head 2.

In particular, as described with reference to Figure 16, the two recesses 10 can be configured and sized so that the distance X3 between their two opposite ends 101 is substantially equal to the length X4 of the covering element 6, while the length X5 of the window 9 results to be shorter than said length X4. Therefore, in order to be able to insert the two short sides 64 of the covering element 6 in the recesses 10 from the side of the inner surface 812 of frame 81, it is first necessary to bend the covering element 6 and then release it so that it assumes its natural configuration and length again.

Furthermore, the same frame 81, always according embodiments of described with reference to Figures 13 and 14, includes at each one of the long sides 92 of the window 9, on the side of its external surface 811, a projection 11 facing towards the inside of the same window 9.

Said two projections 11, as shown for instance Figures 15 and 17, in turn define reference surfaces 12 that are on the opposite side with respect to the external surface 811, in such a way as to limit the extension of the covering element 6 beyond the plane defined by the same external surface 811, once arranged in the window 9.

Figure 17 is used to illustrate yet further embodiments, which can be combined with further embodiments described herein, in which the covering element 6 can be installed within frame 81, according to a cross-section plane orthogonal to the longitudinal axis α of said frame 81 shown for instance in Figure 15.

In other words, the presence of said projections 11 allows the covering element 6 to assume a substantially flattened position, which an be for instance perfectly coplanar with said external surface 811, and the combination of the projections 11 and the recesses 10 clearly can prevent the covering element 6 from accidentally coming off the frame 81. Furthermore, in some implementations which can be used in order to improve the coplanarity between the covering element 6 and the external surface 811 of the frame 81, the long sides 65 of the same covering element 6 can be provided with two recesses 66 suited to be coupled with the projections 11 of the frame 81, as shown for instance in Figures 15 and 17.

In some implementations, as described for instance using Figure 17, the recesses 66 and the projections 11 can be sized so that when the covering element 6 is coupled with the frame 81, the overall thickness X6 defined by each recesses 66 with the relevant projections 11 is substantially equal to the thickness X1 of the covering element 6.

It cannot be excluded, however, that in different or other implementations, the frame 81 can be configured in a different way.

In still other embodiments, frame 81 and covering element 6 can be made as a single piece.

According to embodiments of the application, the removable coupling between the frame 81 and the housing 21 of the print head 2 can be obtained through magnetic members 13.

In particular, the magnetic members 13, as shown for instance in Figure 10, can be arranged in said housing 21 and the frame 81 can be made of a ferromagnetic material so as to be held in position by the action of the magnetic field of the magnetic members 13.

It cannot be excluded, however, that in different or other implementations the coupling elements 8 used for removably coupling the covering element 6 with the printing surface 3 are of a type different from the frame 81.

Furthermore, it cannot be excluded that in alternative or other embodiments of the printing unit 1 according to the present disclosure and described with reference to Figure 10, the covering element 6 can be permanently coupled with the printing surface 3.

It is further provided, according to embodiments of the application an ink jet printing system 100, (see e.g. Figure 2), including printing unit 1 as described herein, in particular for printing legends on the surfaces of printed circuit boards (PCBs).

Furthermore, the present disclosure also relates the use of a covering element 6 provided with one or more apertures 7 and arranged so that it rests on and covers the printing surface 3 of a printing unit 1, in order to allow the ink to be ejected through the plurality of nozzles 4 provided on said printing surface 3 towards the printing plane P. The covering element 6 and the apertures 7 are furthermore sized in such a way as to prevent the light rays R emitted by a light source 5, also belonging to the printing unit 1, and reflected by said printing plane P, from passing through the apertures 7 and directly hitting the printing surface 3. According to the above, it can thus be understood that the printing unit of the application and the printing apparatus of the application achieve all the set objectives.

As an example, two print heads each generating drops of 12 pl volume can be used in possible implementation of the embodiments described herein, which translate into a spot size of about 65 µm. Each print head can have a native resolution of e.g. 360 DPI, such as the combination of the two print heads provides an overall printing resolution of the printing unit of 720 DPI.

In particular, the present disclosure achieves the object to provide a printing unit that is capable of increasing the printing resolution, e.g. to 720 DPI, using a single-pass printing process, by installing the above-mentioned two print heads, where one is shifted by half grid step respect to the other, and the UV pinning light source between the two print heads. For instance, making reference to the afore-described example, the resulting combined printing grid can have a step of 35 µm and the drops with a diameter of 65 µm are overlapping almost 50%. The second print head is shifted half resolution grid step with respect to the first print head and is followed by a UV curing light source, which is much more powerful than the UV pinning light source. The final result obtainable with the printing unit and printing apparatus according to the present disclosure is that a first image, e.g. 360 DPI image, can be printed with a first print head, which is immediately pinned by the UV pinning light source, followed by a second image, e.g. 360 DPI image, with a second print head, which is then cured by the UV curing light source, all in one single pass. Therefore, the present disclosure allows performing a single pass high resolution, e.g. 720 DPI, printing that is totally equivalent to two separate low resolution, e.g. 360 DPI, printing passes.

Moreover, the present disclosure achieves the object to provide a printing unit that is capable of avoiding the polymerization and the accumulation of said highly polymerizable particles on its printing surface and, therefore, is capable of maintaining a high printing quality for a longer time compared to the solutions of the known art, in the same operating conditions.

The present disclosure also achieves the object to provide a printing unit that is capable of maintaining a high printing accuracy.

While the foregoing is directed to embodiments described herein, other and further embodiments may be devised without departing from the basic scope thereof, and the scope thereof is determined by the claims that follow.

## Claims

1. A printing unit (1) configured for ink-jet printing on a substrate, the printing unit (1) comprising:
a first print head (50),
a second print head (52),
a UV pinning light source (54) between the first print head (50) and the second print head (52) and
a UV curing light source (56) on an outer side of one or the other of the first print head (50) and second print head (52).

2. The printing unit (1) in accordance with claim 1, wherein the UV curing light source (56) is disposed on an outer side of the second print head (52).

3. The printing unit (1) in accordance with claim 1 or 2, wherein the UV pinning light source (54) and the UV curing light source (56) are selected from a group consisting of fluorescent lights, fluorescent black lights, short wave ultraviolet lamps, laser, ultraviolet laser, ultraviolet gas laser, high power gas laser, UV laser diodes, UV solid-state lasers, electron beam, illuminator, a monochromatic light source, light emitting diode (LED), LED array, ultraviolet LEDs, gas discharge lamps, argon and deuterium lamps, Hg-Cd lamp, arc lamp, electric arc lamp, flash lamp, Xe or halogen lamp.

4. The printing unit (1) in accordance with claim 1 or 2, wherein the UV pinning light source (54) comprises a UV pinning LED device having a total UV power of between 0.1 W/cm² to 6W/cm².

5. The printing unit (1) in accordance with claim 1 or 2, wherein the UV pinning light source (54) is a UV pinning LED device having a width (BB) of an active emitting window (54a) of between 2 mm to 20 mm.

6. The printing unit (1) in accordance with claim 1 or 2, wherein the UV pinning light source (54) comprises a UV pinning LED device having a UV output of between 365-420nm.

7. The printing unit (1) in accordance with claim 1 or 2, wherein the UV pinning light source (54) is at a distance of between 5 mm to 50 mm from the first print head (50).

8. The printing unit (1) in accordance with claim 1 or 2, wherein the UV pinning light source (54) is provided with Angle Reduction Technology (ART) optic(s).

9. The printing unit (1) in accordance with claim 8, wherein the Angle Reduction Technology (ART) optics comprises one or more collimation lenses (58).

10. The printing unit (1) in accordance with claim 1 or 2, wherein the UV curing light source (56) comprises a UV curing LED device having an irradiance at UV emitting window of between 3W/cm² and 10W/cm².

11. The printing unit (1) in accordance with claim 1 or 2, wherein the UV curing light source (56) comprises a UV curing LED device having a width of between 15 mm to 60 mm.

12. The printing unit (1) in accordance with claim 1 or 2, wherein each of the first print head (50) and second print head (52) is provided with one or more rows of nozzles (51) configured for ink-jetting.

13. A printing apparatus (60) comprising:
a printing unit (1) configured for ink-jet printing on a substrate, the printing unit (1) comprising:
a first print head (50),
a second print head (52),
a UV pinning light source (54) between the first print head (50) and the second print head (52) and
a UV curing light source (56) on an outer side of one or the
other of the first print head (50) and second print head (52), the printing apparatus further comprising a printing substrate support (59) configured for supporting the substrate (100) during a printing process.

14. The printing apparatus (60) in accordance with claim 13, the printing apparatus (60) comprising one or more actuation members (102a, 102b) configured for moving the printing unit (1) and the substrate (100) one relative to the other.
